Europäisches Patentamt

European Patent Office

Office européen des brevets

(11) Publication number: **0 084 000**
**A2**

(12) # EUROPEAN PATENT APPLICATION

(21) Application number: **83400013.5**

(22) Date of filing: **04.01.83**

(51) Int. Cl.³: **H 01 L 27/08**
**H 01 L 29/78**

(30) Priority: **11.01.82 US 338778**

(43) Date of publication of application:
**20.07.83 Bulletin 83/29**

(84) Designated Contracting States:
**DE FR GB IT NL**

(71) Applicant: **FAIRCHILD CAMERA & INSTRUMENT
CORPORATION
464 Ellis Street
Mountain View California 94042(US)**

(72) Inventor: **Chen, Peter Cheng-Yu
1619 Mariani Drive
Sunnyvale California 94087(US)**

(74) Representative: **Chareyron, Lucien et al,
Schlumberger Limited Service Brevets 42, rue
Saint-Dominique
F-75340 Paris Cedex 07(FR)**

(54) CMOS device.

(57) Latch-up in CMOS devices (11c) by conduction of parasitic bipolar transistors (29c, 30c) is prevented by providing a voltage drop between the power supply voltage $(V'_{cc})$ of the CMOS device and a voltage drop between the well region and ground. By providing these voltage drops, the parasitic transistors are prevented from conducting, and the channel lengths decreased, thus increasing current handling ability and decreasing switching times as compared with prior art CMOS devices.

FIG.1c

EP 0 084 000 A2

# CMOS DEVICE

## BACKGROUND OF THE INVENTION

### Field of the Invention

This invention relates to semiconductor devices and, more particularly, to a CMOS structure which is immune to latch-up.

### Description of the Prior Art

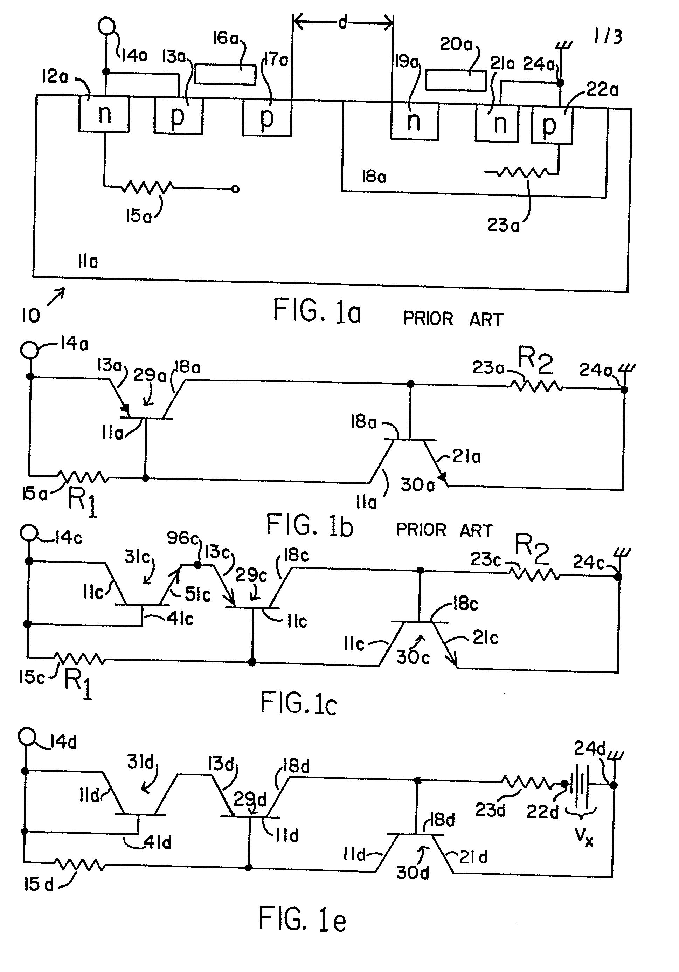

A typical prior art complementary metal oxide silicon (CMOS) device is shown in Figure 1A. CMOS device 10 is formed within N-type substrate 11a. The P-channel device comprises P-type source 13a, P-type drain 17a and gate electrode 16a. A P-type channel is induced within N type substrate 11a between source 13a and drain 17a upon application of a sufficient negative voltage to gate 16a. The N-channel transistor comprises N-type source 19a and N-type drain 21a formed within P-well 18a, and gate electrode 20a. The N-channel is induced within P-well 18a between source 19a and drain 21a when a sufficient positive voltage is applied to gate electrode 20a. The CMOS device 10 includes N-type substrate contact 12a, which provides electrical connection to substrate 11a. CMOS device 10 also includes P-type contact 22a, which provides electrical connection to P-well 18a. The substrate resistance is shown as resistor 15a, and the P-well resistance is shown as resistor 23a.

In addition to the above-described N-channel and P-channel transistors forming CMOS device 10, unwanted or "parasitic" PNP and NPN transistors are formed within substrate 11a of device 10 (Figure 1a). The schematic diagram for the parasitic PNP and NPN transistors of device 10 is shown in Figure 1b. P-type source 13a, N-type substrate 11a, and P-well 18a form parasitic PNP transistor 29a. N-type substrate 11a, P-well 18a, and N-type drain 21a form parasitic NPN transistor 30a. Because the base of PNP transistor 29a and the collector of NPN transistor 30a both comprise the substrate 11a, the circuit diagram of Figure 1b shows an electrical interconnection between the base of PNP transistor 29a and the collector of NPN transistor 30a. Similarly, an electrical interconnection is shown between collector of PNP transistor 29a and the base of NPN transistor 30a because the elements both comprise P-well 18a. Substrate resistance 15a (having a resistance value $R_1$) is shown connected between the emitter of PNP transistor 29a (formed by P-type source 13a) and the base of PNP transistor 29a (formed by the substrate 11a) because P-type source 13a is connected through substrate contact 12a to substrate resistor 15a. In a similar manner, the emitter of NPN transistor 30a is shown connected to node 24a, and P-well resistance 23a (having a resistance value of $R_2$) is shown connected between node 24a and the base of NPN transistor 30a, which is the P-well 18a. Normally, parasitic transistors 29c and 30c are biased off, however, lateral current flow in the substrate 11a and P-well 18a can establish potential differences across resistors 15a and 23a which turn on parasitic transistors 29a and 30a.

In the operation of Figure 1b, node 24a is connected to ground, and terminal 14a is connected to a positive supply voltage ($V_{cc}$), typically 5 volts. Because resistor 15a is connected between the emitter 13a and base 11a of PNP transistor 29a, base 11a is always at a lower potential than emitter 13a. Thus, PNP transistor 29a turns on, thus applying a positive voltage to base 18a of NPN transistor 30a. With emitter 21a of transistor 30a grounded, transistor 30a turns on, thus drawing current to ground 24a through resistor 15a from the positive supply voltage $V_{cc}$ applied to terminal 14a. This in turn increases the voltage drop across resistor 15a, thereby increasing the voltage across the emitter-base junction of PNP transistor 29a, thereby turning transistor 29a on harder. This in turn applies a higher voltage to the base of NPN transistor 30a, thus turning transistor 30a on harder. In this manner, current is drawn from the positive supply voltage $V_{cc}$ applied to terminal 14 through parasitic transistors 29a and 30a to ground. This action is termed "latch-up", and causes a considerable waste of power in CMOS devices. In fact, with a severe case of latch-up, the CMOS device is destroyed due to excessive heat caused by the power dissipation through the parasitic transistors.

One prior art method of preventing, or minimizing, the latch-up problem is to provide a very wide field region between the P-channel device and the N-channel device. In this prior art method of minimizing latch-up, the field region has a minimum width, labelled "d" in Figure 1a, of 10-15 microns. While use of such a large field region serves to reduce the current gain (Beta) of the parasitic bipolar transistors, thus minimizing current flow through the parasitic transistors, the use of such a large field region also reduces the number of CMOS devices which may be fabricated on a given piece of silicon. Therefore, using large field regions to minimize latch-up results in rather low density devices.

Another approach to minimize latch-up in CMOS devices is described by Rung et al. in an article entitled "A Retrograde P-well For Higher Density CMOS", IEEE Transactions on Electron Devices, Volume ED-28, No. 10, October 1981, pages 115-119. Rung et al. teach that a P-well may be formed to a very shallow depth, thereby minimizing lateral diffusion. The Rung P-well utilizes a higher P-type dopant concentration (approximately 2 to $5 \times 10^{17}$ atoms/cm$^3$) than prior art P-wells (which utilize a P-well dopant concentration of approximately $2 \times 10^{16}$ atoms/cm$^3$), thereby minimizing the P-well sheet resistance in order to

0084000   .

minimize latch-up. However, increasing the dopant concentration of the P-well increases the capacitance between P-well 18a and N type source 19a, and between P-well 18a and N type drain 21a, thereby decreasing device speed.

Yet another approach to minimize latch-up in CMOS devices is described by Estreich, et al in an article entitled "An Analysis of Latch-up Prevention in CMOS IC's Using an Epitaxial-Buried Layer Process", IEDM '78 Paper 9.7, December 4-6, 1978, Washington, D.C. and by Payne, et al in an article entitled "Elimination of Latch-up in Bulk CMOS", IEDM '80 Paper 10.2, December 8-10, 1980, Washington, D.C. Estreich, et al and Payne, et al utilize epitaxial silicon formed on a substrate to minimize the sheet resistance of resistor 15a of Figure 1a. Estreich, et al further utilize a buried layer to minimize the resistance of resistor 23a of Figure 1a. The use of epitaxial silicon and buried layers to minimize sheet resistances requires additional processing steps, thus increasing the cost of manufacturing CMOS devices. Furthermore, the requirement of additional processing steps introduces defects, thereby reducing yield.

SUMMARY

This invention prevents latch-up in CMOS devices by preventing conduction of the parasitic transistors. In accordance with this invention, this is accomplished by the addition of a voltage drop means comprising one or more diodes between the power supply voltage ($V_{cc}$), and the positive voltage supply of the CMOS device. By reducing the CMOS device voltage supply to at least one forward-biased diode drop below $V_{cc}$, the parasitic transistors are prevented from conducting.

In another embodiment of this invention, the voltage drop between the base of the parasitic NPN transistor and ground is increased, thereby further preventing the parasitic NPN transistor from conducting, thus increasing the immunity of CMOS devices constructed in accordance with this invention to latch-up and the problems associated therewith.

BRIEF DESCRIPTION OF THE DRAWING

Figure 1a is a representation of a prior art CMOS device;

Figure 1b is a schematic diagram of the parasitic transistors formed within the CMOS device of Figure 1a;

Figure 1c is a schematic diagram of one embodiment of this invention;

Figure 1d is a cross-sectional view of a CMOS device constructed in accordance with this invention;

Figure 1e is a schematic diagram of another embodiment of this invention; and

Figure 2 is a graphical representation of the gate delay versus power supply voltage for several semiconductor technologies.

DETAILED DESCRIPTION

A circuit diagram of one embodiment of this invention is shown in Figure 1c. The parasitic transistors 29c and 30c are shown as in Figure 1b. However, the addition of diode 31c, in accordance with the teachings of this invention, minimizes latch-up resulting from the presence of the parasitic transistors. As shown in Figure 1c, diode 31c may comprise an NPN transistor having its base and collector connected together. Alternatively, 31c may comprise a single PN junction. The device power supply voltage $V_{cc}$ (typically 5 volts) is applied to terminal 14c. Because of the presence of diode 31c, the actual voltage supplied to the active devices is equal to $V_{cc}$

minus voltage drop across a forward biased diode ($V_d$). This voltage is available on node 96c. Because of the addition of diode 31c, the voltage drop across resistor 15c must be greater than $2V_d$ (where $V_d$ is the voltage drop across a forward-biased PN junction) in order to cause parasitic transistor 29c to turn on. Thus, the power supply voltage $V_{cc}$ must forward bias diode 31c, and the emitter-base junction of parasitic transistor 29c, in order to cause transistor 29c to conduct. For most substrates used in semiconductor devices, the substrate resistance 15c ($R_1$) is sufficiently low (e.g., approximately 1000 ohms) to prevent a voltage drop greater than or equal to $2V_d$ between $V_{cc}$ and the base of parasitic PNP transistor 29c. In this manner, parasitic transistor 29c is prevented from conducting. Because transistor 29c does not conduct, a positive voltage is not applied to the base of transistor 30c, and transistor 30c remains turned off, thus eliminating latch-up.

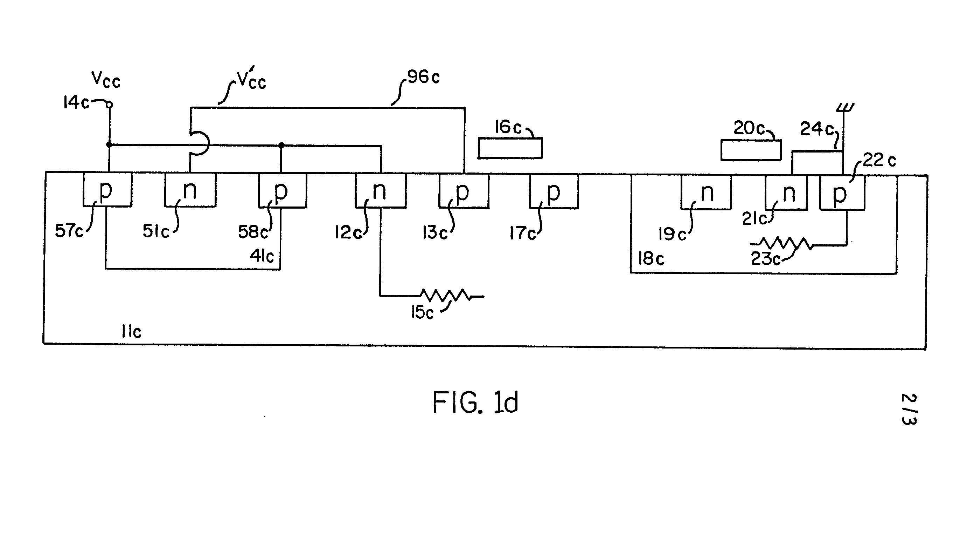

A cross sectional view of the circuit of Figure 1c is shown in Figure 1d. Components similar to the prior art circuits are numbered similarly. However, in accordance with this invention, the structure includes an additional P region 41c forming the base of transistor 31c, contact regions 57c, 58c for contacting P region 41c and N type emitter 51c formed within base 41c. The collector of transistor 31c comprises N type substrate 11c.

In another embodiment of this invention (not shown), N diodes connected in series (where N is a positive integer) are used in place of diode 31c. In this embodiment, the resistor 15c must provide a voltage drop greater than $(N+1)V_d$ in order to cause transistor 29c to conduct. Thus, for any resistance value of resistor 15c less than that required to provide a voltage drop of $(N+1)V_d$, parasitic PNP transistor 29c will not conduct, which in turn prevents the conduction of parasitic NPN transistor 30c, thereby eliminating latch-up.

For integrated circuits employing more than a single CMOS device, a single diode 31c (or set of N diodes connected in series) is employed which is capable of supplying sufficient current to drive the entire integrated circuit device. For a typical CMOS integrated circuit having a power dissipation of approximately 500 milliwatts, and a supply voltage $V_{cc}$ of 5 volts, the diode 31c must be capable of supplying 100 milliamps to the integrated circuit. Utilizing standard P-well dopant concentrations of approximately $2x10^{16}$ atoms/cm$^3$, a diode 31c capable of supplying 100 milliamperes is fabricated in a surface area of only approximately 100 square mils. If higher dopant concentrations are utilized, or if the diode 31c is formed in a separate P-well (as shown in the cross sectional view of Figure 1d) having higher dopant concentrations, the surface area required to fabricate diode 31c may be reduced. For example, with P region 41c having a P type dopant concentration of approximately $2x10^{18}$ atoms/cm$^3$, a diode 31c capable of supplying 100 milliamperes without excessive heat buildup is fabricated in a surface area of approximately 5 square mils. This highly doped P region 41c can also be utilized to fabricate additional bipolar transistors having high current carrying ability, for use other than eliminating latch up.

Utilizing the features of this invention, a CMOS device is fabricated having increased latch-up immunity, thereby allowing the field regions of the device to be reduced in width. For example, while prior art field widths, shown in Figure 1a as distance "d", must be on the order of 1 to 1.5 microns in order to minimize latch-up, utilizing the teachings of this invention a circuit may be constructed wherein the widths of the field regions between P and N channel devices may be reduced to approximately 0.4 microns.

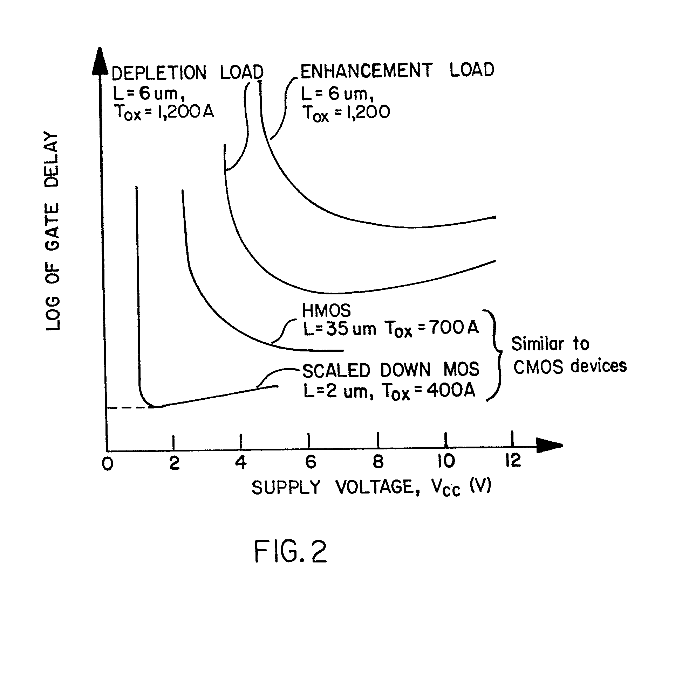

In addition to increasing immunity against latch-up, the speed of the CMOS circuits constructed in accordance with this invention is increased over prior art CMOS devices utilizing an identical $V_{cc}$ of five volts. As shown in Figure 2, the gate delay of MOS devices generally decreases with decreasing power supply voltage for small geometry MOS devices. However, many CMOS devices are powered by $V_{cc}$ = 5 volts in order to be compatible with other circuitry. Utilizing the teaching of this invention, the CMOS device may be powered externally by $V_{cc}$ = 5 volts, thereby maintaining compatibility with other circuitry, while being powered internally by $V_{cc}'$ which is one or more diode drops $(V_d)$ below 5 volts, thereby increasing the speed over prior art CMOS devices.

Yet another advantage of utilizing CMOS devices constructed in accordance with this invention is the fact that P channel devices may be constructed having shorter channel lengths than comparable prior art P channel devices. As shown in Figure 1d, the source 13c is connected to $V_{cc}'$, which is more negative than the substrate 11c connected to $V_{cc}$. Thus, the base-emitter junction formed by P channel source 13c and substrate 11c is reverse-biased, thereby preventing the conduction of the heretofore undiscussed parasitic PNP transistor formed by P type source 13c (forming the emitter) N type substrate 11c (forming the base) and P type drain 17c (forming the collector). Consequently, shorter channel length between P channel source 13c and P channel drain 17c are safely used in CMOS devices constructed in accordance with this invention without the risk of punch-through (punch-through being the flow of current from source to drain due to the operation of the parasitic bipolar transistor formed, in this instance, by the source 13c, the substrate 11c and the drain 17c).

The current driving capability of an MOS device is inversely proportional to the channel length. Therefore, with P channel devices constructed in accordance with this invention having reduced channel lengths as compared with P channel devices of the prior art, CMOS devices may be constructed in accordance with this invention having increased performance and increased speed over prior art CMOS devices.

Another embodiment of this invention is shown in schematic diagram of Figure 1e. This embodiment is similar to the embodiment in schematic diagram of Figure 1c with the addition of a voltage drop $V_x$ inserted between the base 18d of NPN parasitic transistor 30d and ground 24d. This voltage drop $V_x$ tends to reverse-bias the base-emitter junction of parasitic NPN transistor 30d, thus tending to prevent the conduction of NPN transistor 30d. In other words, a substantially greater current must flow through resistor 23d to ground in order to overcome the voltage $V_x$ to forward bias the base-emitter junction of parasitic NPN transistor 30d. Of course, the insertion of voltage drop $V_x$ may be used in conjunction with the voltage drop provided by diode 31c, or the voltage drop $V_x$ may be used alone. In either case, a CMOS device with increased immunity to latch-up is provided, as compared with prior art CMOS devices.

The voltage drop $V_x$ is provided in a number of alternative ways. In one embodiment, node 22d is connected to an external "pin" of the semiconductor package containing the CMOS device. Externally to the semiconductor device, a supply voltage $V_x$ is connected between the pin connected to node 22d and ground.

Alternatively, node 22d is connected to an external pin, and one or more PN junctions are connected in series between the pin connected to node 22d (system ground) and node 24d (CMOS device ground). In this manner, a voltage drop $V_x$ is provided between base 18d and ground.

Yet another technique for providing the voltage drop $V_x$ between base 18d of the parasitic NPN transistor 30d and ground is to provide a back-bias generator on the semiconductor chip containing the CMOS device. Such a back-bias generator is described by Martino, et al in an article entitled "An On-Dash Chip Back-Bias Generator for MOS Dynamic Memory", IEEE Journal of Solid-State Circuits, Vol. SC-15, No. 5, October 1980, pages 820-825. While the Martino, et al article describes a back-bias generator for use in conjunction with MOS memory devices, this back-bias generator can be used to provide the voltage drop $V_x$ on the same silicon chip that contains the remainder of the CMOS device constructed in accordance with this invention. The Martino, et al article is hereby incorporated by reference and, thus, the construction and operation of the back-bias generator will not be described in detail. The use of an on-chip back-bias generator to provide the voltage drop $V_x$ eliminates the need for utilizing an external pin for connection to node 22d.

When the voltage drop $V_x$ is utilized, the N channel device exhibits the same advantages over prior art N channel devices as does the P channel device of this invention over prior art P channel devices. Thus, in accordance with this invention, the use of voltage drop $V_x$ minimizes latch-up problems of CMOS devices, and increases the switching speed of the N channel device, and thus increases the switching speed of the CMOS circuit as a whole constructed in accordance with this invention as compared with prior art CMOS devices due to the decreased power supply voltage applied to the CMOS device. Furthermore, by reverse-biasing the base-emitter junction of the parasitic NPN bipolar transistor formed by N type source 19c (forming the emitter), P well 18c (forming the base) and N type drain 21c (forming the collector) (Figure 1d), CMOS devices are constructed utilizing N channel devices having shorter channel lengths than the N channel devices utilized in prior art CMOS devices, without increased danger of punch-through. Thus, the current handling ability of the N channel transistor, as well as the speed of the N channel transistor, is increased over prior art N channel transistors, thus increasing the current handling ability and speed of the CMOS device constructed in accordance with this invention.

While specific examples and embodiments have been described in this specification, these are intended to be illustrative only and are not to be construed as limitations on the invention. Many other embodiments of this invention will become apparent to those skilled in the art in light of the teachings of this invention. For example, while this specification discloses one embodiment of my invention which is useful in preventing latch up in CMOS devices fabricated using an N type substrate and a P well within the N type substrate, it is apparent in light of this disclosure to those of ordinary skill in the art that this invention may be utilized to prevent latch up in CMOS devices utilizing a P type substrate and N wells formed in said P type substrate.

0084000

CLAIMS

1. A CMOS device comprising:

a first terminal (14) for connection to a source of power;

a second terminal (24) for connection to ground;

a semiconductor substrate (11) of a first conductivity type connected to said first terminal;

a well region (18) of a second conductivity type opposite said first conductivity type formed within said substrate;

a first source region (13) and a first drain region (17) each of said second conductivity type formed within said substrate;

a second source region (19) and a second drain region (21) each of said first conductivity type formed within said well region;

a first gate electrode (16) located above the portion of said substrate between said first source and first drain regions, said first gate electrode being insulated from said substrate;

a second gate electrode (20) located above the portion of said well region between said second source and second drain regions, said second gate electrode being insulated from said well region;

characterized by further comprising:

a voltage drop means (31) connected between said first terminal and said first source region (13), said voltage drop means making said first source region less positive than said first terminal when power is applied to said CMOS device.

2. A CMOS device comprising:

a first terminal (14) for connection to a positive source of power;

a second terminal (24) for connection to ground;

a semiconductor substrate (11) of a first conductivity type connected to said first terminal;

a well region (18) of a second conductivity type opposite said first conductivity type formed within said substrate;

a first source region (13) and a first drain region (17) each of said second conductivity type formed within said substrate;

a second source region (19) and a second drain region (21) each of said first conductivity type formed within said well region;

a first gate electrode (16) located above the portion of said substrate between said first source and first drain regions, said first gate electrode being insulated from said substrate;

a second gate electrode (20) located above the portion of said well region between said second source and second drain regions, said second gate electrode being insulated from said well region;

characterized by further comprising:

a voltage drop means (Vx) connected in series between said second terminal and said well region, said voltage source making said well region negative with respect to ground.

3. The CMOS device of claim 1 further comprising a second voltage drop means connected in series between said second terminal and said well region, said voltage source making said well region negative with respect to ground.

4. The CMOS device of anyone of claims 1 to 3 characterized in that said voltage drop means comprises at least one PN junction diode thereby to substantially reduce the risk of latch-up of said complementary MOS device.

5. The CMOS device of claim 1 or 3 characterized in that said voltage drop means connected to said first terminal comprises:

a plurality of diodes, said diodes being forward biased when power is applied to said CMOS device.

6. The CMOS device of claim 2 or 3 characterized in that said voltage drop means connected to said second terminal comprises a plurality of diodes connected in series.

7. The CMOS device of claim 6 characterized in that one or more of said diodes comprises a bipolar transistor having its collector and base interconnected.

8. The CMOS device of anyone of claims 1 to 7 characterized in that said first conductivity type is N and said second conductivity type is P.

9. The CMOS device of claim 1 combined with claim 5 characterized in that said plurality of diodes are formed in a second well region of high dopant concentration, thereby providing rather small diodes having high current handling ability.

FIG. 1a    PRIOR ART

FIG. 1b    PRIOR ART

FIG.1c

FIG. 1e

FIG. 1d

3/3

FIG. 2